# FASCICULE DE BREVET EUROPEEN

(11) **EP 3 465 759 B1**
(45) Date de publication et mention de la délivrance du brevet: **20.05.2020**
(21) Numéro de dépôt: 17730867.3
(22) Date de dépôt: 22.05.2017
(51) Int. Cl.: H01L 27/146, H01L 31/0203, H05K 9/00, H01L 23/552, G02B 6/42

(54) **ELEMENT DE BLINDAGE ELECTROMAGNETIQUE OPTIQUEMENT TRANSPARENT ET A PLUSIEURS ZONES**
OPTISCH TRANSPARENTES, ELEKTROMAGNETISCH ABSCHIRMENDES ELEMENT MIT EINER VIELZAHL VON ZONEN
OPTICALLY TRANSPARENT ELECTROMAGNETICALLY SHIELDING ELEMENT COMPRISING A PLURALITY OF ZONES

(30) Priorité: 31.05.2016 FR 1654872
(43) Date de publication de la demande: 10.04.2019
(73) Titulaire: Safran Electronics & Defense, 75015 Paris (FR); Centre National de la Recherche Scientifique CNRS, 75016 Paris (FR); Université de Rennes 1, 35000 Rennes (FR)
(72) Inventeur: DUPEYRAT, Cyril, 92100 Boulogne Billancourt (FR); FOUTREL, Patrice, 92100 Boulogne Billancourt (FR); BESNIER, Philippe, 92100 Boulogne Billancourt (FR); CASTEL, Xavier, 92100 Boulogne Billancourt (FR); CORREDORES, Yonathan, 92100 Boulogne Billancourt (FR)
(74) Mandataire: Plasseraud IP
(86) Numéro de dépôt international: PCT/FR2017/051264
(87) Numéro de publication internationale: WO 2017/207893

(56) Documents cités:
- EP-A2- 1 835 522
- WO-A1-2006/122608
- JP-A- 2004 029 153
- US-A1- 2014 169 021
- YAN-JUN SUN, HAO CHANG, SONG-HANG WU, YAN-BING LENG, LI WANG: "Study on Electromagnetic Shielding of Infrared /Visible Optical Window", MODERN APPLIED SCIENCE, vol. 9, no. 13, décembre 2015 (2015-12), pages 231-236, XP002767456, Canadian Center of Science and Education. ISSN: 1913-1844, DOI: 10.5539/mas.v9n13p231

## Description

La présente invention concerne un élément de blindage électromagnétique qui est transparent optiquement, ainsi qu'un procédé de fabrication d'un tel élément de blindage.

De nombreuses applications utilisent des capteurs optiques, par exemple des capteurs sensibles à des rayonnements optiques qui appartiennent au domaine infrarouge, alors que les fonctionnements de tels capteurs peuvent être perturbés par des rayonnements électromagnétiques, notamment du domaine hyperfréquence. Il est alors connu de disposer devant l'entrée optique d'un tel capteur, un élément de blindage qui est au moins partiellement opaque pour une partie des rayonnements hyperfréquences, tout en étant au moins partiellement transparent pour les rayonnements optiques. Pour cela, l'élément de blindage comporte au moins une structure bidimensionnelle qui est conductrice électriquement, en étant au moins partiellement transparente pour les rayonnements optiques.

En outre, pour être efficace, la structure bidimensionnelle conductrice doit être reliée électriquement à la masse électrique d'un support ou d'un véhicule sur lequel le capteur optique est installé. Ainsi, le montage de chaque capteur optique sur son support ou véhicule d'utilisation nécessite des étapes d'assemblage et de fixation de l'élément de blindage devant l'entrée optique du capteur, et des étapes de réalisation d'une connexion électrique qui relie la structure bidimensionnelle conductrice de l'élément de blindage à la masse électrique.

Plus précisément, un tel élément de blindage, tel que connu avant la présente invention, comprend :
- un substrat rigide, qui possède deux faces opposées, et qui est au moins partiellement transparent entre ses deux faces pour au moins un rayonnement électromagnétique qui possède une fréquence f comprise entre 0,1 GHz (gigahertz) et 40 GHz ; et
- au moins une structure bidimensionnelle conductrice électriquement, qui est disposée sur une des faces du substrat, et qui est au moins partiellement transparente pour un rayonnement optique qui possède une longueur d'onde comprise entre 0,2 µm (micromètre) et 15 µm.

Le substrat est aussi au moins partiellement transparent entre ses deux faces pour ce rayonnement optique. Les transmissions optiques considérées, pour le substrat et la structure bidimensionnelle conductrice, sont relatives au rayonnement optique qui est destiné à traverser l'élément de blindage entre les deux faces.

En outre, l'efficacité de blindage, notée EB(f) et exprimée en décibels (dB), est définie par EB(f) = -10·log₁₀(T(f)), où T(f) est un coefficient de transmission énergétique de l'élément de blindage pour le rayonnement électromagnétique qui possède la fréquence f comprise entre 0,1 GHz et 40 GHz, et qui traverse l'élément de blindage entre ses deux faces. Li Wang et al décrit en "Study on Electromagnetic Shielding of Infrared /Visible Optical Window" (Modem Applied Science vol.9 n.13, 231-236 ISSN:1913-1844, XP002767456) un filtre de blindage électromagnétique.

Par ailleurs, des systèmes complexes de détection optique sont maintenant mis en œuvre, qui combinent plusieurs capteurs optiques. Ces capteurs peuvent alors être juxtaposés, par exemple sur une tête de montage à orientation variable. Alors, l'assemblage et la fixation de tous les éléments de blindage électromagnétique qui sont nécessaires pour une telle multiplicité de capteurs optiques - un élément de blindage par capteur - deviennent complexes et fastidieux pour produire le système complet de détection optique. En outre, une connexion électrique distincte doit être réalisée séparément pour chaque élément de blindage, ce qui augmente encore la complexité de la fabrication du système multi-capteurs.

A partir de cette situation, un objectif de l'invention est de réduire la complexité et le coût de fabrication d'un tel système multi-capteurs.

Pour atteindre cet objectif ou un autre, un premier aspect de la présente invention propose un élément de blindage électromagnétique transparent optiquement du type connu rappelé plus haut, mais qui possède plusieurs zones.

Selon une première caractéristique de l'invention, la structure bidimensionnelle conductrice électriquement est disposée sur une des faces du substrat au moins à l'intérieur de plusieurs zones séparées de l'élément de blindage. En outre, elle est au moins partiellement transparente dans chacune des zones pour un rayonnement optique qui possède une longueur d'onde comprise entre 0,2 µm et 15 µm.

Selon une deuxième caractéristique de l'invention, le substrat est au moins partiellement transparent entre ses deux faces pour chaque rayonnement optique, et est continu de matière entre toutes les zones de l'élément de blindage.

Selon une troisième caractéristique de l'invention, la structure bidimensionnelle conductrice électriquement possède au moins un chemin continu de conduction électrique qui relie des parties de la structure bidimensionnelle contenues chacune dans une des zones de l'élément de blindage, pour toutes les zones.

Selon une quatrième caractéristique de l'invention, l'élément de blindage possède dans une première des zones, un premier ensemble de valeurs formé par au moins une valeur de transmission optique et une valeur d'efficacité de blindage, qui est différent d'un second ensemble de valeurs, pour ladite transmission optique et ladite efficacité de blindage, effectif dans une seconde des zones. Pour cette quatrième caractéristique, les valeurs de transmission optique sont relatives à une même longueur d'onde de rayonnement optique, et les valeurs d'efficacité de blindage sont relatives à une même fréquence de rayonnement électromagnétique, pour les première et seconde zones.

Ainsi, l'invention propose un unique élément de blindage qui est adapté pour plusieurs capteurs optiques qui sont juxtaposés. L'assemblage et la fixation de cet élément de blindage unique pour construire un système multi-capteurs, est plus simple que celle de plusieurs éléments de blindage qui sont séparés, si bien que la complexité et le coût de montage du système multi-capteurs sont réduits.

En outre, l'élément de blindage de l'invention intègre la connexion électrique qui relie, les unes aux autres, toutes les parties de structure bidimensionnelle conductrice qui sont contenues dans toutes les zones. Une seule connexion électrique vers l'extérieur de l'élément de blindage, à la masse électrique, est alors suffisante pour l'ensemble de l'élément de blindage, c'est-à-dire pour protéger simultanément par blindage tous les capteurs optiques du système multi-capteurs.

Dans des premières réalisations de l'invention, le substrat peut porter une première structure bidimensionnelle conductrice électriquement sur une première de ses faces dans au moins deux zones séparées de l'élément de blindage, et l'autre face du substrat peut porter simultanément une seconde structure bidimensionnelle conductrice électriquement dans au moins une des deux zones, dite zone à double structure bidimensionnelle. Eventuellement alors, le substrat peut être au moins partiellement transparent pour au moins deux rayonnements électromagnétiques qui possèdent des fréquences respectives différentes comprises entre 0,1 GHz et 40 GHz. Dans ce cas, l'épaisseur du substrat dans la zone à double structure bidimensionnelle, peut être telle que la valeur de l'efficacité de blindage électromagnétique qui est relative à celui des deux rayonnements électromagnétiques ayant la fréquence la plus élevée, est supérieure d'au moins 5 dB, de préférence d'au moins 10 dB, à la valeur de l'efficacité de blindage électromagnétique qui est relative à l'autre des deux rayonnements électromagnétiques, ayant la fréquence la plus faible, lorsque les deux rayonnements électromagnétiques traversent l'élément de blindage entre les deux faces dans la zone à double structure bidimensionnelle.

Possiblement, dans certaines des premières réalisations de l'invention, ladite autre face du substrat peut porter la seconde structure bidimensionnelle conductrice électriquement aussi dans les deux zones séparées de l'élément de blindage, et l'élément de blindage peut alors posséder des valeurs d'une épaisseur du substrat mesurée entre les deux faces, qui sont différentes entre les deux zones séparées de l'élément de blindage.

De façon générale pour l'invention, ladite au moins une structure bidimensionnelle conductrice électriquement peut comprendre une couche d'un métal, de préférence d'argent, ou d'un oxyde transparent conducteur, de préférence d'oxyde d'indium dopé à l'étain, cette couche pouvant avoir une épaisseur qui varie entre deux zones distinctes de l'élément de blindage.

Alternativement, ladite au moins une structure bidimensionnelle conductrice électriquement peut comprendre une grille électriquement conductrice qui est formée sur la face du substrat. Dans ce cas, cette grille peut posséder au moins une valeur d'un paramètre sélectionné parmi un pas de grille, une largeur de fil de la grille et une épaisseur de matériau conducteur formant la grille, qui est différente entre deux des zones de l'élément de blindage. Le pas de grille et la largeur de fil sont mesurés parallèlement à la face du substrat, et l'épaisseur de métal est mesurée perpendiculairement à la face du substrat.

Lorsque l'élément de blindage est en outre du type de l'une des premières réalisations, c'est-à-dire à deux structures bidimensionnelles conductrices, la première et la seconde structure bidimensionnelle conductrice électriquement peuvent comprendre chacune une grille conductrice, dans au moins une même des deux zones de l'élément de blindage, dite zone à double grille. Les deux faces du substrat peuvent alors être parallèles dans la zone à double grille, et l'une des deux grilles est avantageusement en alignement avec une partie au moins de l'autre grille dans la zone à double grille, selon une direction qui est perpendiculaire aux deux faces. De cette façon, l'occultation optique totale qui est provoquée par les deux grilles dans la zone à double grille, est réduite, et approximativement équivalente à l'occultation que provoquerait une seule des grilles.

Par ailleurs, un second aspect de l'invention propose un système de détection qui comprend au moins deux capteurs optiques et un élément de blindage conforme au premier aspect de l'invention. Les capteurs sont fixés par rapport à l'élément de blindage de sorte qu'une première des zones de l'élément de blindage reste située entre une entrée de rayonnement optique dans un premier des capteurs et un champ optique d'entrée de ce premier capteur, et une seconde des zones de l'élément de blindage reste située entre une entrée de rayonnement optique dans un second des capteurs et un champ optique d'entrée de ce second capteur.

Enfin, un troisième aspect de l'invention propose un procédé de fabrication d'un élément de blindage qui est conforme au premier aspect de l'invention. Un tel procédé comprend les étapes suivantes :
- fournir le substrat, sous forme d'une pièce rigide qui est continue de matière entre toutes les zones ; et
- sur l'une au moins des faces du substrat, déposer au moins un matériau électriquement conducteur de façon à former une partie au moins de ladite au moins une structure bidimensionnelle conductrice électriquement, dans certaines au moins des zones de l'élément de blindage en même temps qu'une partie au moins du chemin continu de conduction électrique.

Lorsque le substrat possède une épaisseur qui varie entre deux zones de l'élément de blindage, et comporte les première et seconde structures bidimensionnelles conductrices chacune dans ces deux zones, le procédé peut comprendre en outre les étapes suivantes :
- usiner ou polir le substrat dans l'une au moins des deux zones ; et
- déposer au moins un matériau électriquement conducteur sur ladite autre face du substrat de façon à former une partie au moins de ladite seconde structure bidimensionnelle conductrice électriquement dans l'une au moins des deux zones de l'élément de blindage.

Dans ce cas, lors du dépôt de matériau électriquement conducteur sur ladite autre face du substrat, une partie au moins de ladite seconde structure bidimensionnelle conductrice électriquement peut être formée dans l'une au moins des deux zones de l'élément de blindage en même temps qu'une partie au moins d'un autre chemin continu de conduction électrique qui relie, l'une à l'autre sur ladite autre face du substrat, des parties de ladite seconde structure bidimensionnelle conductrice électriquement contenues chacune dans une des deux zones de l'élément de blindage.

Lorsque l'une des structures bidimensionnelles conductrices électriquement est une grille, un matériau conducteur qui forme une partie au moins de cette grille peut être déposé sur le substrat, puis gravé sélectivement en utilisant un procédé de photolithogravure à résine positive. Alternativement, un motif complémentaire de la grille peut être produit sur le substrat au moyen d'une résine négative, puis un matériau conducteur de la grille peut être déposé sur le substrat dans des parties de celui-ci qui sont dépourvues de résine, et la résine du motif complémentaire est ensuite retirée.

Enfin, lorsque l'épaisseur du matériau conducteur de la grille est différente entre deux des zones du substrat, le dépôt de la structure bidimensionnelle conductrice électriquement peut comprendre au moins les sous-étapes suivantes :
- réaliser une partie initiale de la structure bidimensionnelle conductrice électriquement simultanément dans les deux zones, cette partie initiale ayant un motif de grille et étant elle-même conductrice électriquement ; puis
- au moins dans celle des zones où l'épaisseur du matériau conducteur de la grille est destinée à être la plus importante, effectuer un dépôt de matériau conducteur supplémentaire par électrolyse, sur la partie initiale de la structure bidimensionnelle conductrice électriquement.

Une telle méthode est assez rapide et économique pour obtenir des épaisseurs de matériau conducteur déposé qui sont importantes et variables entre des zones différentes.

D'autres particularités et avantages de la présente invention apparaîtront dans la description ci-après d'exemples de réalisation non limitatifs, en référence aux dessins annexés, dans lesquels :
- la figure 1 illustre un système de détection optique conforme à la présente invention ;
- les figures 2a à 2e sont des vues en coupe de plusieurs éléments de blindage conformes à l'invention ;
- la figure 3 illustre un perfectionnement applicable à des éléments de blindage conformes aux figures 2c à 2e ; et
- la figure 4 est une vue en perspective d'un substrat adapté pour des réalisations particulières d'un élément de blindage encore conforme à la présente invention.

Pour raison de clarté, les dimensions qui apparaissent dans ces figures ne correspondent ni à des dimensions réelles ni à des rapports de dimensions réels. En outre, des références identiques qui sont indiquées dans des figures différentes désignent des éléments identiques ou qui ont des fonctions identiques.

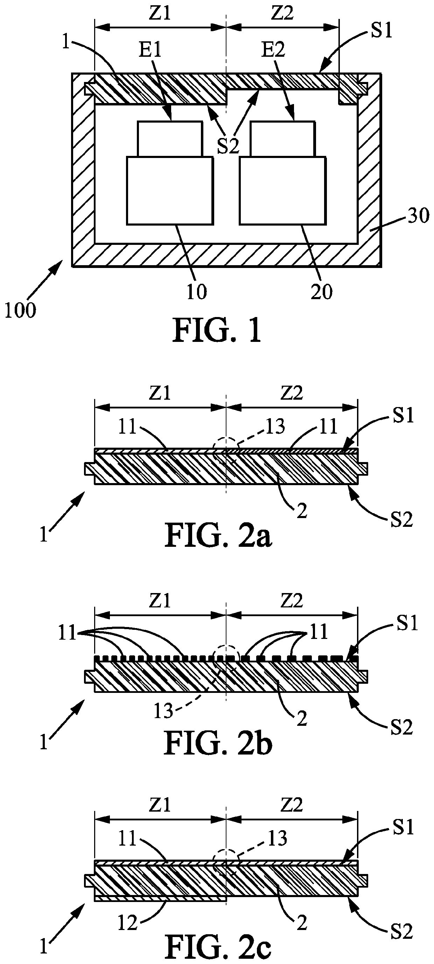

Conformément à la figure 1, un système de détection 100 comprend deux capteurs optiques 10 et 20, qui sont juxtaposés dans un boîtier 30. Les deux capteurs 10, 20 sont destinés à recevoir chacun, en fonctionnement, des rayonnements optiques utiles dont les longueurs d'onde sont comprises entre 0,2 µm (micromètre) et 15 µm, par l'entrée optique E1 pour le capteur 10, et par l'entrée optique E2 pour le capteur 20. Les rayonnements optiques utiles des deux capteurs 10 et 20 n'ont pas nécessairement des longueurs d'onde identiques à l'intérieur de l'intervalle 0,2 µm - 15 µm.

Or les capteurs 10 et 20 peuvent être perturbés par des rayonnements électromagnétiques externes dont des fréquences sont comprises entre 0,1 GHz (gigahertz) et 40 GHz, notamment des rayonnements de brouillage adverses. Il est alors nécessaire de protéger les capteurs 10 et 20 contre de tels rayonnements électromagnétiques, par des éléments qui sont au moins partiellement opaques à ces rayonnements électromagnétiques. De tels éléments de protection contre des perturbations électromagnétiques sont appelés éléments de blindage dans le jargon de l'Homme du métier. Le boîtier 30 peut avoir une telle fonction de blindage, mais surtout une fenêtre 1 à fonction de blindage, appelée élément de blindage transparent optiquement dans la partie générale de la présente description, est disposée devant les entrées optiques E1 et E2 des deux capteurs 10 et 20. Selon l'invention, la fenêtre 1 est formée par un seul composant solide, et est conçue pour satisfaire simultanément des exigences optiques et de blindage qui sont relatives aux deux capteurs 10 et 20. Pour cela, la fenêtre 1 possède un premier ensemble de caractéristiques optiques et de blindage dans une première zone Z1 de cette fenêtre, qui destinée à être située devant l'entrée optique E1 au sein du système 100, et un second ensemble de caractéristiques optiques et de blindage dans une seconde zone Z2, qui destinée à être située devant l'entrée optique E2. Les zones Z1 et Z2 de la fenêtre 1 peuvent être adjacentes, mais aussi séparées par une bande intermédiaire, notamment en fonction de l'écartement entre les entrées optiques E1 et E2. Les caractéristiques optiques et de blindage de la fenêtre 1 dans chacune des zones Z1 et Z2 sont adaptées en fonction du capteur 10 ou 20 auquel cette zone est dédiée. En particulier, les deux capteurs 10 et 20 peuvent avoir des domaines de sensibilité optique qui sont différents à l'intérieur de l'intervalle de longueur d'onde 0,2 µm - 15 µm. Ils peuvent aussi présenter des exigences de blindage qui sont différentes, par rapport à certains rayonnements électromagnétiques à l'intérieur de l'intervalle de fréquence 0,1 GHz - 40 GHz.

Or un blindage électromagnétique est obtenu en ajoutant une structure bidimensionnelle qui est conductrice électriquement sur l'une au moins des faces S1 et S2 de la fenêtre 1. L'efficacité du blindage et d'autant plus élevée que la conductance électrique de cette structure bidimensionnelle est elle-même élevée. Mais alors la transparence optique de la fenêtre 1 peut être réduite par la structure bidimensionnelle, lorsque la conductance électrique de cette dernière est importante et si cette dernière est homogène (non maillée). Or la sensibilité de chaque voie optique dépend du niveau de transparence de la fenêtre 1 dans la zone Z1 ou Z2 de celle-ci qui est située devant l'entrée optique du capteur de cette voie.

La présente invention permet de combiner dans la même pièce de fenêtre 1 deux compromis différents entre transparence optique et efficacité de blindage, qui sont dédiés séparément à l'un et à l'autre des capteurs 10 et 20.

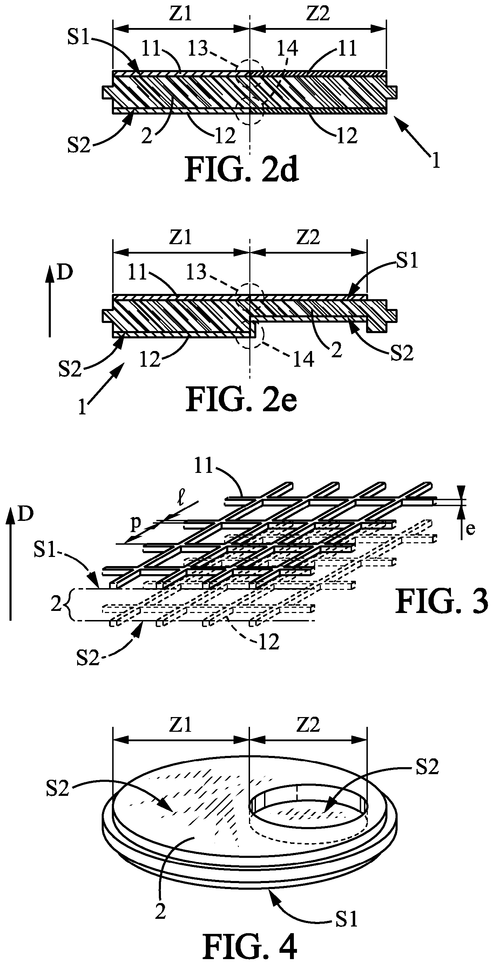

Ainsi, et de façon générale pour l'invention, la fenêtre 1 comprend un substrat 2 et au moins une structure bidimensionnelle, qui est conductrice électriquement et référencée 11 (figures 2a à 2e et 3). Le substrat 2 est au moins partiellement transparent optiquement dans chacune des zones Z1 et Z2, pour le rayonnement optique utile du capteur 10 ou 20 qui correspond à cette zone. De façon préférentielle, le substrat 2 est une pièce de composition homogène, si bien qu'il est transparent dans les deux zones Z1 et Z2 simultanément pour les rayonnements optiques utiles des deux capteurs 10 et 20. Le substrat 2 peut être à base de silicium (Si), de germanium (Ge), de sulfure de zinc (ZnS), de silice (SiO₂), d'oxyde d'aluminium (Al₂O₃) ou d'oxyde de magnésium (MgO), par exemple.

La fonction de blindage électromagnétique est produite par la structure bidimensionnelle 11, éventuellement combinée avec une seconde structure bidimensionnelle conductrice électriquement, qui est aussi incorporée dans la fenêtre 1 et référencée 12 (figures 2c à 2e et 3).

Dans le mode de réalisation de la figure 2a, la fenêtre 1 ne comporte qu'une seule structure bidimensionnelle, référencée 11, qui est disposée sur la face S1 du substrat 2. Alternativement, la structure bidimensionnelle 11 peut être disposée sur la face S2 du substrat 2. La structure bidimensionnelle 11 possède des constitutions différentes dans les deux zones Z1 et Z2, pour produire simultanément les compromis de transparence optique et d'efficacité de blindage qui sont appropriés l'un pour le capteur 10, et l'autre pour le capteur 20.

Selon un premier type de constitution possible pour la structure bidimensionnelle 11 dans l'une au moins des zones Z1 et Z2, elle peut comprendre un empilement de couches minces, avec l'une au moins de ces couches qui est conductrice électriquement pour produire la fonction de blindage. Cette couche conductrice électriquement peut être en argent (Ag), ou en oxyde d'indium dopé à l'étain (ITO pour «indium-tin oxide» en anglais), par exemple. L'efficacité de blindage est d'autant plus élevée que l'épaisseur de cette couche conductrice est importante, perpendiculairement à la face du substrat 2. Mais alors la transparence optique de cette couche conductrice décroît, par effet de réflexion et/ou d'absorption. L'Homme du métier connaît alors des combinaisons de couches diélectriques avec une ou plusieurs couches conductrices, en sélectionnant de façon appropriée l'épaisseur de chaque couche et l'indice de réfraction de chaque matériau diélectrique utilisé, pour produire une transparence optique et une efficacité de blindage qui soient simultanément suffisantes pour le capteur concerné. Ainsi, la structure bidimensionnelle 11 peut être un empilement de couches métalliques et diélectriques, dont la série de couches, le nombre des couches, les épaisseurs de couches, et/ou les matériaux des couches, peuvent différer entre les deux zones Z1 et Z2 (figure 2a). De telles couches minces peuvent être déposées par l'une des techniques aussi connues de l'Homme du métier, telles que la pulvérisation cathodique, l'évaporation sous vide, l'ablation laser ou le dépôt en phase vapeur assisté par plasma, couramment désigné par PE-CVD, pour «plasma-assisted chemical vapour deposition» en anglais.

Selon un second type de constitution possible pour la structure bidimensionnelle 11 dans l'une au moins des zones Z1 et Z2, la structure bidimensionnelle 11 peut être constituée par une grille de fils conducteurs dans chacune des zones Z1 et Z2, comme représenté dans la figure 2b. Une telle grille peut posséder un motif carré de maille, par exemple, et est constituée de fils conducteurs, par exemple de métal : cuivre ou argent, qui sont disposés sur la face S1 du substrat 2. Les paramètres dont dépend la conductance électrique apparente de la structure bidimensionnelle 11 sont le pas de la grille, la largeur des fils de la grille, et une épaisseur du matériau conducteur qui forme les fils de la grille, le pas de la grille et la largeur des fils étant mesurés parallèlement à la face S1 du substrat 2, et l'épaisseur de matériau conducteur étant mesurée perpendiculairement à cette face. Les grilles qui sont formées dans l'une et l'autre des zones Z1 et Z2 de la fenêtre 1 ont l'un au moins de ces trois paramètres qui varie entre les deux zones pour produire le compromis entre transparence optique et efficacité de blindage qui est adapté à chacun des capteurs 10, 20, séparément dans la zone Z1 ou Z2 qui est dédiée à ce capteur. Pour une telle constitution à grilles, la transmission optique de la structure bidimensionnelle 11 dans chaque zone Z1, Z2 dépend de l'occultation que produisent les fils de grille dans cette zone. Selon une méthode possible de formation d'une grille conductrice sur le substrat 2, un motif conducteur de grille peut être d'abord formé sur la face S1 en utilisant une résine lithographique positive ou négative. Si une résine lithographique positive est utilisée, une couche continue de matériau conducteur, notamment d'argent ou de cuivre, est d'abord déposée sur la face S1, éventuellement après une couche d'accrochage. Une couche de résine lithographique positive est ensuite déposée sur la couche conductrice, et insolée au travers d'un masque selon un motif identique à celui des fils de la grille. La résine est ensuite développée aux endroits insolés, puis la couche conductrice est gravée, de préférence chimiquement, aux endroits où elle n'est plus protégée par la résine. Si une résine lithographique négative est utilisée, une couche continue de résine lithographique est d'abord déposée sur la face S1, et insolée au travers d'un masque selon un motif identique à celui des fils de la grille. La résine est ensuite développée aux endroits non insolés et donc retirée sélectivement aux endroits des fils à former. Le matériau conducteur est alors déposé à la fois sur la résine et aux endroits de la face S1 qui sont dépourvus de résine, puis toute la résine est définitivement retirée par dissolution dans un solvant adapté, de sorte qu'il ne reste du matériau conducteur qu'aux endroits voulus pour les fils dans la face S1. Une telle seconde méthode est connue sous le vocable «lift-off» dans le jargon de l'Homme du métier. Une fois que le motif conducteur de grille, appelé partie initiale de la structure bidimensionnelle dans la partie générale de la présente description, a été déposé selon l'une de ces deux méthodes à résine lithographique positive ou négative, l'épaisseur de matériau conducteur dans l'une au moins des deux zones Z1, Z2 peut être augmentée rapidement en ajoutant un dépôt complémentaire du matériau, cette fois par électrolyse. Le motif conducteur de grille sert alors d'électrode sur laquelle du matériau conducteur supplémentaire va être réduit et déposé par électrolyse. Un tel dépôt supplémentaire de matériau conducteur peut être effectué avec des épaisseurs qui sont différentes entre les deux zones Z1 et Z2, en variant les durées d'électrolyse entre ces deux zones. La figure 2b illustre une réalisation dans laquelle le pas de grille et la largeur des fils sont supérieurs dans la zone Z2 par rapport à la zone Z1.

D'autres réalisations de l'invention peuvent aussi être obtenues en adoptant une constitution à empilement de couches minces dans l'une des deux zones Z1 et Z2, et une constitution à grille de matériau conducteur dans l'autre zone, pour la structure bidimensionnelle 11.

Dans tous les cas, et selon un avantage important que procure l'invention, les deux parties de structure bidimensionnelle conductrice 11 qui sont formées sur la face S1 du substrat 2, respectivement dans la zone Z1 et dans la zone Z2, peuvent être produites avec un chemin de conduction électrique 13 qui les relie l'une à l'autre. Selon les constitutions adoptées pour la structure bidimensionnelle conductrice 11 dans les deux zones Z1 et Z2, ce chemin de conduction électrique peut être une continuité de la structure bidimensionnelle 11 entre les deux zones Z1 ou Z2, ou un recouvrement des deux parties de la structure bidimensionnelle 11 qui sont dédiées aux zones Z1 et Z2, respectivement, ce recouvrement produisant un raccordement électrique et étant formé dans une bande de la face S1 qui est intermédiaire entre les deux zones Z1 et Z2. Alternativement, le chemin de conduction électrique 13 peut aussi être constitué par un dépôt conducteur complémentaire qui est en contact électriquement avec les deux parties de la structure bidimensionnelle 11 contenues séparément dans les zones Z1 et Z2. Toutefois, les modes de réalisation pour lesquels le chemin de conduction électrique 13 est formé en même temps que l'une au moins des deux parties de la structure bidimensionnelle 11, sont préférés. Ainsi, la fenêtre 1 est fournie directement avec un chemin continu de conduction électrique pour la structure bidimensionnelle 11 entre les deux zones Z1 et Z2, avant d'être assemblée avec boîtier 30. Il ne reste donc plus qu'une seule connexion électrique à réaliser, pour relier électriquement la structure bidimensionnelle 11 au boîtier 30 ou à la masse électrique.

La figure 2c illustre encore un autre mode de réalisation de l'invention, dans lequel la fenêtre 1 comporte encore la structure bidimensionnelle 11 sur la face S1 du substrat 2, mais comporte en outre une structure bidimensionnelle conductrice supplémentaire 12 dans l'une des deux zones Z1, Z2, par exemple la zone Z1, sur la face S2. La structure bidimensionnelle conductrice 12 peut avoir l'une des constitutions déjà décrites, à empilement de couches minces ou à grille. Elle permet d'augmenter sélectivement l'efficacité de blindage dans la zone Z1, par rapport au blindage que procure la structure dimensionnelle 11 seule.

La figure 2d illustre encore un autre mode de réalisation de l'invention, dans lequel les deux structures bidimensionnelles conductrices 11 et 12 s'étendent chacune dans les deux zones Z1 et Z2, respectivement sur la face S1 et sur la face S2 du substrat 2. Toutes les combinaisons de constitutions de structure bidimensionnelle conductrice qui ont déjà été décrites, peuvent être utilisées indépendamment pour former les structures bidimensionnelles 11 et 12 dans les deux zones Z1 et Z2. Il est ainsi plus facile de réaliser la fenêtre 1 avec des valeurs imposées, pour la transmission optique et pour l'efficacité de blindage, dont l'une au moins diffère entre les deux zones Z1 et Z2. Dans un mode de réalisation de l'invention avantageux et conforme à la figure 2d, la structure bidimensionnelle 12 comporte aussi un chemin continu de conduction électrique 14, qui relie les deux parties de la structure bidimensionnelle conductrice 12, l'une à l'autre entre les deux zones Z1 et Z2. Le chemin de conduction électrique 14 peut avoir une constitution analogue à l'une de celles décrites plus haut pour le chemin de conduction électrique 13 de la structure bidimensionnelle 11.

De façon générale, augmenter l'épaisseur totale de matériau conducteur qui est portée par l'ensemble des deux faces S1 et S2 du substrat 2 dans une même des deux zones Z1, Z2, augmente la valeur qui est obtenue dans cette zone pour l'efficacité du blindage.

La figure 3 illustre un perfectionnement possible lorsque les deux structures bidimensionnelles 11 et 12 ont des constitutions en grilles dans une même des deux zones Z1, Z2. De préférence, les deux grilles respectives des structures 11 et 12 sont alignées l'une par rapport à l'autre selon une direction D qui est perpendiculaire aux deux faces S1 et S2, celles-ci étant parallèles l'une à l'autre. Un tel perfectionnement permet de réduire la diminution totale de transmission optique qui est provoquée par les deux structures en grilles. En effet, chaque grille est en général opaque optiquement, et l'occultation totale qui est provoquée par les deux grilles est alors sensiblement équivalente à l'occultation d'une seule de celles-ci, le pas de la deuxième grille étant égal à un multiple entier du pas de la première grille. Sur la figure 3, les notations p, I et e désignent respectivement le pas, la largeur de fil et l'épaisseur de fil pour l'une des deux grilles.

Un autre avantage de disposer des structures bidimensionnelles sur les deux faces S1 et S2 du substrat 2 dans une même des deux zones Z1 et Z2 (figures 2c à 2e) est la possibilité d'obtenir une valeur d'efficacité de blindage à une première valeur de fréquence à l'intérieur de l'intervalle 0,1 GHz - 40 GHz, qui est supérieure à la valeur d'efficacité de blindage à une seconde valeur de fréquence aussi à l'intérieur de l'intervalle 0,1 GHz - 40 GHz, alors que la première valeur de fréquence est supérieure à la seconde valeur de fréquence. L'écart entre les deux valeurs d'efficacité de blindage peut être supérieur à 5 dB (décibel), voir supérieur à 10 dB. Cette relation d'ordre entre les deux valeurs d'efficacité de blindage est permise par un effet d'interférence ondulatoire qui apparaît entre les deux structures bidimensionnelles 11 et 12, lorsque l'épaisseur du substrat 2 entre celles-ci est adaptée par rapport à la fréquence des rayonnements électromagnétiques considérés. En effet, les deux structures bidimensionnelles 11 et 12, en vis-à-vis sur les deux faces S1 et S2 du substrat 2, constituent, pour le rayonnement électromagnétique, un dispositif de Fabry-Pérot bien connu de l'Homme du métier.

Les figures 2e et 4 illustrent des modes de réalisation particuliers de l'invention, dans lesquels l'épaisseur du substrat 2 est différente entre les deux zones Z1 et Z2. Une telle variation d'épaisseur peut être utile lorsque les deux structures bidimensionnelles conductrices 11 et 12 recouvrent les deux faces S1 et S2, respectivement, chacune dans les deux zones Z1 et Z2, pour produire l'effet d'interférence ondulatoire qui vient d'être expliqué. Ainsi, sur ces deux figures, l'épaisseur du substrat 2, mesurée parallèlement à la direction D, est plus grande dans la zone Z1 que dans la zone Z2. Par exemple, le substrat 2 peut être produit par moulage d'un matériau thermodurcissable directement avec les épaisseurs définitives dans les deux zones Z1 et Z2. Alternativement, le substrat 2 peut être produit initialement avec une épaisseur identique dans les deux zones Z1 et Z2, puis il est aminci par usinage et/ou polissage dans la zone Z2. Eventuellement, et notamment lorsqu'il est en saphir (Al₂O₃), le substrat 2 peut être produit avec une épaisseur dans la zone Z2 qui est inférieure à celle dans la zone Z1, et les deux épaisseurs sont ensuite ajustées par usinage, rectification et/ou polissage pour obtenir les valeurs d'épaisseur définitives. De préférence, le procédé de réalisation du chemin de conduction électrique 14 est compatible avec la présence d'une marche dans la face S2 entre les deux zones Z1 et Z2. Pour cela, des procédés de dépôt de matériaux qui ne sont pas directionnels, tels que l'évaporation, le dépôt chimique en phase vapeur assisté par plasma, ou l'électrolyse, pourront être préférés.

Les tableaux suivants 1 à 4 regroupent des valeurs qui ont été obtenues pour la transmission optique et l'efficacité de blindage, pour quatre exemples de fenêtres conformes à l'invention. Les substrats utilisés sont en verre (1^{er} à 3^{ème} exemples) ou en saphir (4^{ème} exemple), la transmission optique, notée Tₒₚₜ est donnée pour les deux valeurs de longueur d'onde de 1 µm et 10 µm, et l'efficacité de blindage, EB(f) = -10·log₁₀(T(f)) est donnée pour les deux fréquences f de 1 GHz et 20 GHz.

**Tableau 1**

| 1^{er} exemple | Zone Z1 | Zone Z2 |
|---|---|---|
| Epaisseur du substrat (verre B) | 2 mm | 2 mm |
| Constitution de la structure bidimensionnelle 11 | Grille (Ag) | Grille (Ag) |
| | p = 300 µm | p = 300 µm |
| | l = 20 µm | l = 20 µm |
| | e = 400 nm | e = 80 nm |
| Pas de structure bidimensionnelle 12 | | |
| Tₒₚₜ(0,5 µm) en % | 79 | 79 |
| Tₒₚₜ(2,5 µm) en % | 76 | 76 |
| EB(2 GHz) en dB | 40 | 35 |
| EB(20 GHz) en dB | 16 | 16 |

**Tableau 2**

| 2^{ème} exemple | Zone Z1 | Zone Z2 |
|---|---|---|
| Epaisseur du substrat (verre B) | 0,7 mm | 0,7 mm |
| Constitution de la structure bidimensionnelle 11 | Couche homogène (Ag) e = 10 nm | Couche homogène (Ag) e = 10 nm |
| Constitution de la structure bidimensionnelle 12 | Pas de structure bidimensionnelle 12 | Couche homogène (Ag) e = 10 nm |
| Tₒₚₜ(0,400µm) en % | 73 | 63 |
| Tₒₚₜ(0,535 µm) en % | 65 | 52 |
| EB(2 GHz) en dB | 31 | 35 |
| EB(18 GHz) en dB | 29 | 50 |

**Tableau 3**

| 3^{ème} exemple | Zone Z1 | Zone Z2 |
|---|---|---|
| Epaisseur du substrat (verre B) | 4 mm | 6 mm |
| Constitution de la structure bidimensionnelle 11 | Grille (Ag) | Grille (Ag) |
| | p = 550 µm | p = 550 µm |
| | l = 24 µm | l = 24 µm |
| | e = 100 nm | e = 100 nm |
| Constitution de la structure bidimensionnelle 12 | Grille (Ag) | Grille (Ag) |
| | p = 550 µm | p = 550 µm |
| | l = 24 µm | l = 24 µm |
| | e = 100 nm | e = 100 nm |
| Tₒₚₜ(0,4 µm) en % | 77% | 77% |
| Tₒₚₜ(1 µm) en % | 77% | 77% |
| EB(9 GHz) en dB | 37 | 17 |
| EB(14 GHz) en dB | 18 | 33 |

**Tableau 4**

| 4^{ème} exemple | Zone Z1 | Zone Z2 |
|---|---|---|
| Epaisseur du substrat (Saphir) | 4 mm | 4 mm |
| Constitution de la structure bidimensionnelle 11 | Couche homogène (ITO) e = 200 nm | Couche homogène (ITO) e = 100 nm |

| Constitution de la structure bidimensionnelle 12 | Pas de structure bidimensionnelle 12 | Couche homogène (ITO) e = 100 nm |
|---|---|---|
| Tₒₚₜ(1 µm) en % | 85 | 71 |
| Tₒₚₜ(2 µm) en % | 60 | 10 |
| EB(2 GHz) en dB | 18 | 19 |
| EB(9 GHz) en dB | 13 | 20 |
| EB(14 GHz) en dB | 18 | 22 |

Il est entendu que l'invention peut être reproduite en modifiant certains aspects secondaires de celle-ci par rapport aux exemples de réalisation qui ont été décrits en détail ci-dessus. En particulier, les procédés de dépôt utilisés pour former les structures bidimensionnelles conductrices, et les valeurs numériques, qui ont été cités ne l'ont été qu'à titre d'exemple et peuvent être adaptés en fonction de chaque application de l'invention.

Un substrat 2 qui est conformé peut être aussi utilisé et adapté en fonction de chaque application de l'invention.

Une grille formant structure bidimensionnelle pourra aussi posséder un motif rectangulaire, hexagonal, triangulaire, circulaire, trapézoïdale, etc., tout en satisfaisant les performances requises en termes d'efficacité de blindage et de transparence optique.

Un maillage apériodique, par exemple de type Voronoï, pourra aussi être utilisé afin de s'affranchir du phénomène de Moiré qui est lié à la superposition de réseaux périodiques, tout en conservant des performances d'efficacité de blindage et de transparence optique qui sont similaires.

## Revendications

1. Elément de blindage électromagnétique transparent optiquement (1) et à plusieurs zones (Z1, Z2), qui est adapté pour plusieurs capteurs optiques qui sont juxtaposés, l'elément de blindage comprenant :
- un substrat (2) rigide ayant deux faces (S1, S2) opposées, au moins partiellement transparent entre lesdites deux faces pour au moins un rayonnement électromagnétique qui possède une fréquence f comprise entre 0,1 GHz et 40 GHz ; et
- au moins une structure bidimensionnelle conductrice électriquement (11), qui est disposée sur une des faces (S1, S2) du substrat (2) au moins à l'intérieur de plusieurs zones (Z1, Z2) séparées de l'élément de blindage (1), et qui est au moins partiellement transparente dans chacune desdites zones pour un rayonnement optique qui possède une longueur d'onde comprise entre 0,2 µm et 15 µm ;
le substrat (2) étant aussi au moins partiellement transparent entre les deux faces (S1, S2) pour chaque rayonnement optique, et le substrat étant continu de matière entre toutes les zones (Z1, Z2) de l'élément (1) de blindage,
la structure bidimensionnelle conductrice électriquement (11) ayant au moins un chemin continu de conduction électrique (13) qui relie des parties de ladite structure bidimensionnelle contenues chacune dans une des zones (Z1, Z2) de l'élément de blindage (1), pour toutes lesdites zones,
**caractérisé en ce que** l'élément de blindage (1) possède dans une première des zones (Z1), un premier ensemble de valeurs formé par au moins une valeur de transmission optique et une valeur d'efficacité de blindage, qui est différent d'un second ensemble de valeurs, pour ladite transmission optique et ladite efficacité de blindage, effectif dans une seconde (Z2) des zones, les valeurs de transmission optique étant relatives à une même longueur d'onde de rayonnement optique, et les valeurs d'efficacité de blindage étant relatives à une même fréquence de rayonnement électromagnétique, pour lesdites première et seconde zones, la transmission optique étant relative au rayonnement optique qui est destiné à traverser ledit élément de blindage (1) dans chaque zone (Z1, Z2) entre les deux faces (S1, S2) ; et
l'efficacité de blindage, notée EB(f) et exprimée en décibels, étant définie par EB(f) = -10·log₁₀(T(f)), où T(f) est un coefficient de transmission énergétique de l'élément de blindage pour le rayonnement électromagnétique qui possède la fréquence f comprise entre 0,1 GHz et 40 GHz, et qui traverse ledit élément de blindage (1) entre les deux faces (S1, S2) dans chaque zone (Z1, Z2).

2. Elément de blindage (1) selon la revendication 1, dans lequel le substrat (2) porte une première structure bidimensionnelle conductrice électriquement (11) sur une première des faces (S1) dans au moins deux zones (Z1, Z2) séparées de l'élément de blindage, et l'autre face (S2) du substrat porte une seconde structure bidimensionnelle conductrice électriquement (12) dans au moins une des deux zones, dite zone à double structure bidimensionnelle.

3. Elément de blindage (1) selon la revendication 2, dans lequel le substrat (2) est au moins partiellement transparent pour au moins deux rayonnements électromagnétiques qui possèdent des fréquences respectives différentes comprises entre 0,1 GHz et 40 GHz,
et dans lequel l'épaisseur du substrat (2) dans la zone à double structure bidimensionnelle, est telle que la valeur de l'efficacité de blindage électromagnétique qui est relative à celui des deux rayonnements électromagnétiques ayant la fréquence la plus élevée, est supérieure d'au moins 5 dB, de préférence d'au moins 10 dB, à la valeur de l'efficacité de blindage électromagnétique qui est relative à l'autre des deux rayonnements électromagnétiques, ayant la fréquence la plus faible, lorsque les deux rayonnements électromagnétiques traversent l'élément de blindage (1) entre les deux faces (S1, S2) dans la zone à double structure bidimensionnelle.

4. Elément de blindage (1) selon la revendication 2 ou 3, dans lequel ladite autre face du substrat (S2) porte la seconde structure bidimensionnelle conductrice électriquement (12) aussi dans les deux zones (Z1, Z2) séparées de l'élément de blindage, et l'élément de blindage possède des valeurs différentes d'une épaisseur du substrat (2) mesurée entre les deux faces (S1, S2), dans l'une et l'autre des deux zones séparées de l'élément de blindage.

5. Elément de blindage (1) selon l'une quelconque des revendications 1 à 4, dans lequel ladite au moins une structure bidimensionnelle conductrice électriquement (11) comprend une couche d'un métal, de préférence d'argent, ou d'un oxyde transparent conducteur, de préférence d'oxyde d'indium dopé à l'étain, ladite couche pouvant avoir une épaisseur qui varie entre deux zones (Z1, Z2) distinctes de l'élément de blindage.

6. Elément de blindage (1) selon l'une quelconque des revendications 1 à 4, dans lequel ladite au moins une structure bidimensionnelle conductrice électriquement (11) comprend une grille de matériau conducteur formée sur la face (S1) du substrat (2).

7. Elément de blindage (1) selon la revendication 6, dans lequel ladite grille possède au moins une valeur d'un paramètre sélectionné parmi un pas (p) de grille, une largeur (l) de fil dans la grille et une épaisseur (e) de matériau conducteur formant la grille, qui est différente entre deux des zones (Z1, Z2) de l'élément de blindage, le pas de grille et la largeur de fil étant mesurés parallèlement à la face (S1) du substrat (2), et l'épaisseur de métal étant mesurée perpendiculairement à la face du substrat.

8. Elément de blindage (1) selon la revendication 6 ou 7, avec l'une quelconque des revendications 2 à 4, dans lequel la première (11) et la seconde (12) structure bidimensionnelle conductrice électriquement comprennent chacune une grille de matériau conducteur, dans au moins une même des deux zones (Z1, Z2) de l'élément de blindage, dite zone à double grille, les deux faces (S1, S2) du substrat (2) étant parallèles dans la zone à double grille, et l'une des deux grilles est en alignement avec une partie au moins de l'autre grille dans la zone à double grille, selon une direction (D) qui est perpendiculaire aux deux faces.

9. Système de détection (100) comprenant au moins deux capteurs optiques (10, 20) et un élément de blindage (1) conforme à l'une quelconque des revendications 1 à 8, les capteurs étant fixés par rapport à l'élément de blindage de sorte qu'une première (Z1) des zones dudit élément de blindage reste située entre une entrée (E1) de rayonnement optique dans un premier (10) des capteurs et un champ optique d'entrée dudit premier capteur, et une seconde (Z2) des zones dudit élément de blindage reste située entre une entrée (E2) de rayonnement optique dans un second des capteurs et un champ optique d'entrée dudit second capteur.

10. Procédé de fabrication d'un élément de blindage (1) conforme à l'une quelconque des revendications 1 à 8, le procédé comprenant :
- fournir le substrat (2), sous forme d'une pièce rigide qui est continue de matière entre toutes les zones (Z1, Z2) ; et
- sur l'une au moins des faces (S1) du substrat (2), déposer au moins un matériau électriquement conducteur de façon à former une partie au moins de ladite au moins une structure bidimensionnelle conductrice électriquement (11), dans certaines au moins des zones (Z1, Z2) de l'élément de blindage (1) en même temps qu'une partie au moins du chemin continu de conduction électrique (13).

11. Procédé selon la revendication 10, dans lequel l'élément de blindage (1) est conforme à la revendication 4, le procédé comprenant en outre les étapes suivantes :
- usiner ou polir le substrat (2) dans l'une au moins des deux zones (Z1, Z2) de l'élément de blindage (1) ; et
- déposer au moins un matériau électriquement conducteur sur ladite autre face (S2) du substrat (2) de façon à former une partie au moins de ladite seconde structure bidimensionnelle conductrice électriquement (12) dans l'une au moins des deux zones (Z1, Z2) de l'élément de blindage (1).

12. Procédé selon la revendication 11, suivant lequel lors du dépôt de matériau électriquement conducteur sur l'autre face (S2) du substrat (2), une partie au moins de ladite seconde structure bidimensionnelle conductrice électriquement (12) est formée dans l'une au moins des deux zones (Z1, Z2) de l'élément de blindage (1) en même temps qu'une partie au moins d'un autre chemin continu de conduction électrique (14) qui relie, l'une à l'autre sur ladite autre face du substrat, des parties de ladite seconde structure bidimensionnelle conductrice électriquement contenues chacune dans une des deux zones de l'élément de blindage.

13. Procédé selon l'une quelconque des revendications 10 à 12, dans lequel l'élément de blindage (1) est conforme à la revendication 6, et suivant lequel un matériau conducteur formant une partie au moins de la grille est déposé sur le substrat (2), puis gravé sélectivement en utilisant un procédé de photolithogravure à résine positive.

14. Procédé selon l'une quelconque des revendications 10 à 12, dans lequel l'élément de blindage (1) est conforme à la revendication 6, et suivant lequel un motif complémentaire de la grille est produit sur le substrat (2) au moyen d'une résine négative, puis un matériau conducteur de la grille est déposé sur le substrat dans des parties dudit substrat qui sont dépourvues de résine, et la résine du motif complémentaire est ensuite retirée.

15. Procédé selon l'une quelconque des revendications 10 à 14, dans lequel l'élément de blindage (1) est conforme à la revendication 7, avec l'épaisseur de matériau conducteur de la grille qui est différente entre deux des zones (Z1, Z2) du substrat (2), et suivant lequel le dépôt de la structure bidimensionnelle conductrice électriquement (11) comprend au moins les sous-étapes suivantes :
- réaliser une partie initiale de la structure bidimensionnelle conductrice électriquement (11) simultanément dans les deux zones (Z1, Z2), ladite partie initiale ayant un motif de grille et étant elle-même conductrice électriquement ; puis
- au moins dans celle des zones où l'épaisseur du matériau conducteur de la grille est destinée à être la plus importante, effectuer un dépôt de matériau conducteur supplémentaire par électrolyse, sur la partie initiale de la structure bidimensionnelle conductrice électriquement.

## Patentansprüche

1. Optisch transparentes, elektromagnetisch Abschirmelement (1) mit mehreren Bereichen (Z1, Z2), welches für mehrere optische Sensoren ausgelegt ist, welche nebeneinander angeordnet sind, wobei das Abschirmelement umfasst:
- ein starres Substrat (2) mit zwei gegenüberliegenden Seiten (S1, S2), das zwischen den zwei Seiten wenigstens teilweise transparent für wenigstens eine elektromagnetische Strahlung ist, welche eine Frequenz f zwischen 0,1 GHz und 40 GHz besitzt; und
- wenigstens eine elektrisch leitende zweidimensionale Struktur (11), welche auf einer der Seiten (S1, S2) des Substrats (2) wenigstens im Inneren von mehreren getrennten Bereichen (Z1, Z2) des Abschirmelements (1) angeordnet ist und welche in jedem der Bereiche wenigstens teilweise transparent für eine optische Strahlung ist, welche eine Wellenlänge zwischen 0,2 µm und 15 µm besitzt;
wobei das Substrat (2) ebenfalls zwischen den zwei Seiten (S1, S2) wenigstens teilweise transparent für jede optische Strahlung ist und das Substrat zwischen allen Bereichen (Z1, Z2) des Abschirmelements (1) stoffschlüssig zusammenhängend ist,
wobei die elektrisch leitende zweidimensionale Struktur (11) wenigstens einen durchgehenden elektrisch leitenden Weg (13) aufweist, welcher Teile der zweidimensionalen Struktur verbindet, die jeweils in einem der Bereiche (Z1, Z2) des Abschirmelements (1) enthalten sind, für alle diese Bereiche,
**dadurch gekennzeichnet, dass** das Abschirmelement (1) in einem ersten der Bereiche (Z1) eine erste Menge von Werten besitzt, die von wenigstens einem Wert der optischen Transmission und einem Wert der Abschirmwirkung gebildet wird und die verschieden von einer zweiten Menge von Werten für die optische Transmission und die Abschirmwirkung ist, die in einem zweiten (Z2) der Bereiche wirksam ist, wobei für den ersten und zweiten Bereich die Werte der optischen Transmission sich auf ein und dieselbe Wellenlänge der optischen Strahlung beziehen und die Werte der Abschirmwirkung sich auf ein und dieselbe Frequenz der elektromagnetischen Strahlung beziehen,
wobei sich die optische Transmission auf die optische Strahlung bezieht, welche dazu bestimmt ist, das Abschirmelement (1) in jedem Bereich (Z1, Z2) zwischen den zwei Seiten (S1, S2) zu durchqueren; und
wobei die Abschirmwirkung, mit EB(f) bezeichnet und in Dezibel ausgedrückt, durch EB (f) = -10·log₁₀ (T(f)) definiert ist, wobei T(f) ein Koeffizient der Energieübertragung des Abschirmelements für die elektromagnetische Strahlung ist, welche die Frequenz f zwischen 0,1 GHz und 40 GHz besitzt und welche das Abschirmelement (1) zwischen den zwei Seiten (S1, S2) in jedem Bereich (Z1, Z2) durchquert.

2. Abschirmelement (1) nach Anspruch 1, wobei das Substrat (2) eine erste elektrisch leitende zweidimensionale Struktur (11) auf einer ersten der Seiten (S1) in wenigstens zwei getrennten Bereichen (Z1, Z2) des Abschirmelements trägt und die andere Seite (S2) des Substrats eine zweite elektrisch leitende zweidimensionale Struktur (12) in wenigstens einem der zwei Bereiche, Bereich mit doppelter zweidimensionaler Struktur genannt, trägt.

3. Abschirmelement (1) nach Anspruch 2, wobei das Substrat (2) wenigstens teilweise transparent für wenigstens zwei elektromagnetische Strahlungen ist, welche unterschiedliche jeweilige Frequenzen zwischen 0,1 GHz und 40 GHz besitzen,
und wobei die Dicke des Substrats (2) in dem Bereich mit doppelter zweidimensionaler Struktur eine solche ist, dass der Wert der elektromagnetischen Abschirmwirkung, welcher sich auf diejenige der zwei elektromagnetischen Strahlungen bezieht, welche die höchste Frequenz hat, um wenigstens 5 dB, vorzugsweise um wenigstens 10 dB größer als der Wert der elektromagnetischen Abschirmwirkung ist, welcher sich auf die andere der zwei elektromagnetischen Strahlungen bezieht, welche die niedrigste Frequenz hat, wenn die zwei elektromagnetischen Strahlungen das Abschirmelement (1) zwischen den zwei Seiten (S1, S2) in dem Bereich mit doppelter zweidimensionaler Struktur durchqueren.

4. Abschirmelement (1) nach Anspruch 2 oder 3, wobei die andere Seite des Substrats (S2) die zweite elektrisch leitende zweidimensionale Struktur (12) ebenfalls in den beiden getrennten Bereichen (Z1, Z2) des Abschirmelements trägt und das Abschirmelement in dem einen und dem anderen der beiden getrennten Bereiche des Abschirmelements verschiedene Werte einer zwischen den zwei Seiten (S1, S2) gemessenen Dicke des Substrats (2) besitzt.

5. Abschirmelement (1) nach einem der Ansprüche 1 bis 4, wobei die wenigstens eine elektrisch leitende zweidimensionale Struktur (11) eine Schicht eines Metalls, vorzugsweise von Silber, oder eines leitenden transparenten Oxids, vorzugsweise von zinndotiertem Indiumoxid, umfasst, wobei die Schicht eine Dicke aufweisen kann, welche zwischen zwei verschiedenen Bereichen (Z1, Z2) des Abschirmelements variiert.

6. Abschirmelement (1) nach einem der Ansprüche 1 bis 4, wobei die wenigstens eine elektrisch leitende zweidimensionale Struktur (11) ein Gitter aus leitendem Material umfasst, das auf der Seite (S1) des Substrats (2) ausgebildet ist.

7. Abschirmelement (1) nach Anspruch 6, wobei das Gitter wenigstens einen Wert eines aus einem Gitterabstand (p), einer Drahtbreite (1) in dem Gitter und einer Dicke (e) des das Gitter bildenden leitenden Materials ausgewählten Parameters besitzt, welcher für zwei der Bereiche (Z1, Z2) des Abschirmelements verschieden ist, wobei der Gitterabstand und die Drahtbreite parallel zu der Seite (S1) des Substrats (2) gemessen werden und die Metalldicke senkrecht zu der Seite des Substrats gemessen wird.

8. Abschirmelement (1) nach Anspruch 6 oder 7 mit einem der Ansprüche 2 bis 4, wobei die erste (11) und die zweite (12) elektrisch leitende zweidimensionale Struktur jeweils ein Gitter aus leitendem Material in wenigstens einem gleichen der zwei Bereiche (Z1, Z2) des Abschirmelements, Bereich mit doppeltem Gitter genannt, umfassen, wobei die zwei Seiten (S1, S2) des Substrats (2) in dem Bereich mit doppeltem Gitter parallel sind und das eine der beiden Gitter mit wenigstens einem Teil des anderen Gitters in dem Bereich mit doppeltem Gitter in einer Richtung (D), welche zu den beiden Seiten senkrecht ist, ausgerichtet ist.

9. Detektionssystem (100), welches wenigstens zwei optische Sensoren (10, 20) und ein Abschirmelement (1) gemäß einem der Ansprüche 1 bis 8 umfasst, wobei die Sensoren in Bezug auf das Abschirmelement derart befestigt sind, dass ein erster (Z1) der Bereiche des Abschirmelements zwischen einem Eingang (E1) für optische Strahlung in einem ersten (10) der Sensoren und einem optischen Eingangsfeld des ersten Sensors angeordnet bleibt und ein zweiter (Z2) der Bereiche des Abschirmelements zwischen einem Eingang (E2) für optische Strahlung in einem zweiten der Sensoren und einem optischen Eingangsfeld des zweiten Sensors angeordnet bleibt.

10. Verfahren zur Herstellung eines Abschirmelements (1) gemäß einem der Ansprüche 1 bis 8, wobei das Verfahren umfasst:
- Bereitstellen des Substrats (2) in Form eines starren Teils, das zwischen allen Bereichen (Z1, Z2) stoffschlüssig zusammenhängend ist; und
auf wenigstens einer der Seiten (S1) des Substrats (2), Aufbringen wenigstens eines elektrisch leitenden Materials, um wenigstens einen Teil der wenigstens einen elektrisch leitenden zweidimensionalen Struktur (11) in wenigstens einigen der Bereiche (Z1, Z2) des Abschirmelements (1) auszubilden, gleichzeitig mit wenigstens einem Teil des durchgehenden elektrisch leitenden Weges (13).

11. Verfahren nach Anspruch 10, wobei das Abschirmelement (1) dem Anspruch 4 entspricht, wobei das Verfahren außerdem die folgenden Schritte umfasst:
- Bearbeiten oder Polieren des Substrats (2) in wenigstens einem der zwei Bereiche (Z1, Z2) des Abschirmelements (1); und
- Aufbringen wenigstens eines elektrisch leitenden Materials auf die andere Seite (S2) des Substrats (2), um wenigstens einen Teil der zweiten elektrisch leitenden zweidimensionalen Struktur (12) in wenigstens einem der zwei Bereiche (Z1, Z2) des Abschirmelements (1) auszubilden.

12. Verfahren nach Anspruch 11, gemäß dem bei der Aufbringung von elektrisch leitendem Material auf die andere Seite (S2) des Substrats (2) wenigstens ein Teil der zweiten elektrisch leitenden zweidimensionalen Struktur (12) in wenigstens einem der zwei Bereiche (Z1, Z2) des Abschirmelements (1) gleichzeitig mit wenigstens einem Teil eines anderen durchgehenden elektrisch leitenden Weges (14) ausgebildet wird, welcher Teile der zweiten elektrisch leitenden zweidimensionalen Struktur, die jeweils in einem der zwei Bereiche des Abschirmelements enthalten sind, auf der anderen Seite des Substrats miteinander verbindet.

13. Verfahren nach einem der Ansprüche 10 bis 12, wobei das Abschirmelement (1) dem Anspruch 6 entspricht und gemäß dem ein leitendes Material, das wenigstens einen Teil des Gitters bildet, auf das Substrat (2) aufgebracht und anschließend, unter Anwendung eines Verfahrens der Photolithographie mit Positivlack, selektiv geätzt wird.

14. Verfahren nach einem der Ansprüche 10 bis 12, wobei das Abschirmelement (1) dem Anspruch 6 entspricht und gemäß dem ein komplementäres Muster des Gitters auf dem Substrat (2) mittels eines Negativlacks erzeugt wird, anschließend ein leitendes Material des Gitters in Teilen des Substrats, welche nicht mit Lack versehen sind, auf das Substrat aufgebracht wird und der Lack des komplementären Musters anschließend entfernt wird.

15. Verfahren nach einem der Ansprüche 10 bis 14, wobei das Abschirmelement (1) dem Anspruch 7 entspricht, mit der Dicke des leitenden Materials des Gitters, welche für zwei der Bereiche (Z1, Z2) des Substrats (2) verschieden ist, und gemäß dem die Aufbringung der elektrisch leitenden zweidimensionalen Struktur (11) wenigstens die folgenden Teilschritte umfasst:
- Herstellen eines Anfangsteils der elektrisch leitenden zweidimensionalen Struktur (11) gleichzeitig in den zwei Bereichen (Z1, Z2), wobei der Anfangsteil ein Gittermuster aufweist und selbst elektrisch leitend ist; anschließend
- wenigstens in demjenigen der Bereiche, wo die Dicke des leitenden Materials des Gitters am größten werden soll, Durchführen einer Abscheidung von zusätzlichem leitendem Material durch Elektrolyse auf den Anfangsteil der elektrisch leitenden zweidimensionalen Struktur.

## Claims

1. Optically transparent electromagnetically shielding element (1) having multiple zones (Z1, Z2), that is suitable for several optical sensors which are juxtaposed, comprising:
- a rigid substrate (2) having two opposite faces (S1, S2), at least partially transparent between said two faces to at least one electromagnetic radiation having a frequency f between 0.1 GHz and 40 GHz; and
- at least one electrically conductive two-dimensional structure (11) which is arranged on one of the faces (S1, S2) of the substrate (2), at least within multiple separate zones (Z1, Z2) of the shielding element (1), and which is at least partially transparent in each of said zones to optical radiation having a wavelength between 0.2 µm and 15 µm;
the substrate (2) also being at least partially transparent between the two faces (S1, S2) to each optical radiation, and the substrate being of continuous material between all zones (Z1, Z2) of the shielding element (1),
the electrically conductive two-dimensional structure (11) having at least one continuous electrical conduction path (13) that connects portions of said two-dimensional structure each contained in one of the zones (Z1, Z2) of the shielding element (1), for all of said zones,
**characterized in that** the shielding element (1) has, in a first (Z1) of the zones, a first set of values formed by at least one optical transmission value and a shielding efficiency value, which is different from a second set of values for said optical transmission and said shielding efficiency, effective in a second (Z2) of the zones, the optical transmission values relating to one same wavelength of optical radiation, and the shielding efficiency values relating to one same frequency of electromagnetic radiation, for said first and second zones,
the optical transmission relating to the optical radiation which is intended to pass through said shielding element (1) in each zone (Z1, Z2) between the two faces (S1, S2); and
the shielding efficiency, denoted EB(f) and expressed in decibels, being defined by EB(f) = -10·log₁₀(T(f)), where T(f) is an energy transmission coefficient of the shielding element for electromagnetic radiation having a frequency f between 0.1 GHz and 40 GHz, and which passes through said shielding element (1) between the two faces (S1, S2) in each zone (Z1, Z2).

2. Shielding element (1) according to claim 1, wherein the substrate (2) bears a first electrically conductive two-dimensional structure (11) on a first of the faces (S1) in at least two separate zones (Z1, Z2) of the shielding element, and the other face (S2) of the substrate bears a second electrically conductive two-dimensional structure (12) in at least one of the two zones, referred to as a the zone with double two-dimensional structures.

3. Shielding element (1) according to claim 2, wherein the substrate (2) is at least partially transparent to at least two electromagnetic radiations having different respective frequencies between 0.1 GHz and 40 GHz,
and wherein the thickness of the substrate (2) in the zone with double two-dimensional structures is such that the value of the electromagnetic shielding efficiency relating to the one of the two electromagnetic radiations having the highest frequency is greater, by at least 5 dB and preferably at least 10 dB, than the value of the electromagnetic shielding efficiency relating to the other of the two electromagnetic radiations having the lowest frequency, when the two electromagnetic radiations pass through the shielding element (1) between the two faces (S1, S2) in the zone with double two-dimensional structures.

4. Shielding element (1) according to claim 2 or 3, wherein said other face of the substrate (S2) bears the second electrically conductive two-dimensional structure (12) also in the two separate zones (Z1, Z2) of the shielding element, and the shielding element has values for a thickness of the substrate (2) measured between the two faces (S1, S2) which are different in the two separate zones of the shielding element.

5. Shielding element (1) according to any one of claims 1 to 4, wherein said at least one electrically conductive two-dimensional structure (11) comprises a layer of a metal, preferably silver, or of a transparent conductive oxide, preferably tin-doped indium oxide, said layer possibly having a thickness that varies between two different zones (Z1, Z2) of the shielding element.

6. Shielding element (1) according to any one of claims 1 to 4, wherein said at least one electrically conductive two-dimensional structure (11) comprises a grid of conductive material formed on the face (S1) of the substrate (2).

7. Shielding element (1) according to claim 6, wherein said grid has at least one value for a parameter selected among a grid pitch (p), a grid wire width (I), and a thickness (e) of the conductive material forming the grid, which is different between two of the zones (Z1, Z2) of the shielding element, the grid pitch and wire width being measured parallel to the face (S1) of the substrate (2), and the metal thickness being measured perpendicularly to the face of the substrate.

8. Shielding element (1) according to claim 6 or 7, combined with any one of claims 2 to 4, wherein the first (11) and second (12) electrically conductive two-dimensional structures each comprise a grid of conductive material in at least a same one of the two zones (Z1, Z2) of the shielding element, referred to as a double-grid zone, the two faces (S1, S2) of the substrate (2) being parallel in the double-grid zone, and one of the two grids being in alignment with at least a portion of the other grid in the double-grid zone, in a direction (D) which is perpendicular to the two faces.

9. Detection system (100) comprising at least two optical sensors (10, 20) and a shielding element (1) according to any one of claims 1 to 8, wherein the sensors are fixed relative to the shielding element such that a first (Z1) of the zones of said shielding element remains located between an optical radiation input (E1) into a first (10) of the sensors and an optical input field of said first sensor, and a second (Z2) of the zones of said shielding element remains located between an optical radiation input (E2) into a second of the sensors and an optical input field of said second sensor.

10. Method for manufacturing a shielding element (1) according to any one of claims 1 to 8, the method comprising:
- providing the substrate (2), in the form of a rigid part which is of continuous material between all zones (Z1, Z2); and
- on at least one face (S1) of the substrate (2), depositing at least one electrically conductive material so as to form at least a portion of said at least one electrically conductive two-dimensional structure (11), in at least some of the zones (Z1, Z2) of the shielding element (1), at the same time as at least a portion of the continuous electrical conduction path (13).

11. Method according to claim 10, wherein the shielding element (1) is according to claim 4, the method further comprising the following steps:
- machining or polishing the substrate (2) in at least one of the two zones (Z1, Z2) of the shielding element (1); and
- depositing at least one electrically conductive material on said other face (S2) of the substrate (2) so as to form at least a portion of said second electrically conductive two-dimensional structure (12) in at least one of the two zones (Z1, Z2) of the shielding element (1).

12. Method according to claim 11, wherein, during the deposition of electrically conductive material on the other face (S2) of the substrate (2), at least a portion of said second electrically conductive two-dimensional structure (12) is formed in at least one of the two zones (Z1, Z2) of the shielding element (1) at the same time as at least a portion of another continuous electrical conduction path (14) which interconnects, on said other face of the substrate, portions of said second electrically conductive two-dimensional structure that are each contained in one of the two zones of the shielding element.

13. Method according to any one of claims 10 to 12, the shielding element (1) being according to claim 6, and wherein a conductive material forming at least a portion of the grid is deposited on the substrate (2) and then selectively etched using a process of positive resist photolithography.

14. Method according to any one of claims 10 to 12, the shielding element (1) being according to claim 6, and wherein a pattern complementary to the grid is produced on the substrate (2) by means of a negative resist, then a conductive material of the grid is deposited on the substrate in portions of said substrate which are devoid of resist, and the resist of the complementary pattern is then removed.

15. Method according to any one of claims 10 to 14, the shielding element (1) being according to claim 7, wherein the thickness of the conductive material of the grid is different between two of the zones (Z1, Z2) of the substrate (2), and wherein the deposition of the electrically conductive two-dimensional structure (11) comprises at least the following substeps:
- creating an initial portion of the electrically conductive two-dimensional structure (11) simultaneously in the two zones (Z1, Z2), said initial portion having a grid pattern and itself being electrically conductive; then
- at least in the one of the zones where the thickness of the conductive material of the grid is intended to be the greatest, electrodepositing additional conductive material on the initial portion of the electrically conductive two-dimensional structure.
